**Europäisches Patentamt**

**European Patent Office**

**Office européen des brevets**

(19)

(11) Veröffentlichungsnummer: **0 062 108**
**B1**

(12)

# EUROPÄISCHE PATENTSCHRIFT

(45) Veröffentlichungstag der Patentschrift:
**22.05.85**

(51) Int. Cl.⁴: **H 05 K 7/14**

(21) Anmeldenummer: **81109142.0**

(22) Anmeldetag: **28.10.81**

(54) **Magazin für einschiebbare elektrische Baugruppen.**

(30) Priorität: 30.03.81 DE 3112527
30.03.81 DE 3112505
30.03.81 DE 3112620
30.03.81 DE 8109388 U

(43) Veröffentlichungstag der Anmeldung:
**13.10.82 Patentblatt 82/41**

(45) Bekanntmachung des Hinweises auf die Patenterteilung:
**22.05.85 Patentblatt 85/21**

(84) Benannte Vertragsstaaten:
**AT BE CH FR GB IT LI NL**

(56) Entgegenhaltungen:
**DE - A - 2 714 562**
**DE - B - 1 271 793**
**GB - A - 1 065 158**

(73) Patentinhaber: **Siemens Aktiengesellschaft, Berlin und München Wittelsbacherplatz 2, D-8000 München 2 (DE)**

(72) Erfinder: **Niggl, Heinz-Jürgen, Lindenberg 149, D-8134 Pöcking (DE)**
Erfinder: **Zell, Karl, Moritz-von-Schwind-Weg 80, D-8130 Niederpöcking (DE)**
Erfinder: **Resch, Reinhold, Hauzenberger Strasse 8, D-8000 München 21 (DE)**

# Beschreibung

Die Erfindung bezieht sich auf ein Magazin zur Aufnahme von einschiebbaren elektrischen Baugruppen, die in Führungsschienen gehalten sind, welche an sich quer zu diesen erstreckenden U-förmigen Trägern anliegen.

Es ist bekannt, die senkrecht stehenden flachen Baugruppen in Führungsschienen aufzunehmen, die in Ausnehmungen von sich waagerecht erstreckenden Trägern des Magazins gehalten sind. Die Ausnehmungen sind entsprechend der Baugruppenteilung längs des Trägers gleichmässig verteilt angeordnet. Die Träger sind aus Flachmaterial gebogen und bereits vor dem Biegen durchgehend mit den Ausnehmungen versehen. Sie werden in diesem Zustand als Meterware bereit gestellt und je nach Magazinbreite auf Länge geschnitten. Die Ausnehmungen zur Aufnahme der Führungsschienen sind als sägezahnartige Einkerbungen an den Seitenkanten sowie als Durchbrüche an den Biegekanten des Trägers ausgebildet.

Zur Erhöhung der mechanischen Stabilität des Baugruppenrahmens sind einzelne Stützbleche zwischen jeweils zwei Baugruppen parallel zu diesen angeordnet und an den Trägern befestigt. In den Stützblechen sind entsprechend dem Querschnitt der Träger bemessene Durchbrüche vorgesehen, durch die die Träger hindurchgesteckt sind. Die seitliche Fixierung der Stützbleche erfolgt mittels eines Verbindungsstückes, das an dem Stützblech angeschraubt ist und in eine der Ausnehmungen des Trägers eingreift.

Die Träger sind an ihren Enden an Seitenblechen des Magazins befestigt. Sie weisen an ihren Stirnseiten Vorsprünge auf, die in entsprechende Durchbrüche der Seitenbleche eingreifen. Die U-förmigen Träger weisen an ihren Enden in den Seitenschenkeln Durchbrüche auf, in die jeweils eine Steckmutter eingesetzt ist. Diese Steckmutter ist mittels einer Schraube mit den Seitenblechen des Magazins verspannt, wodurch der Träger sicher an dem Seitenblech gehalten ist. Noch vor dem Biegen der Träger werden die Durchbrüche für die Steckmuttern und die stirnseitigen Vorsprünge z. B. durch Stanzen ausgebildet.

Die Führungsschienen für die Baugruppen weisen eine nutförmige Führungsbahn auf. Auf der der Führungsnut abgewandten Seite ragen starre nasenartige Vorsprünge der Führungsschiene in entsprechende Ausnehmungen der Träger hinein und hintergreifen diese. Beim Einbau der Führungsschienen müssen diese in Längsrichtung verschoben werden. In ihrer Endstellung wird die Führungsschiene durch einen Anschlag gesichert.

Der Erfindung liegt die Aufgabe zugrunde, die Herstellung des Baugruppenrahmens und dessen Montage zu vereinfachen.

Diese Aufgabe wird durch die Erfindung gemäss Anspruch 1 gelöst. Durch die Ausbildung der Vorsprünge ist es möglich, den Träger im Bereich der Ausnehmungen in einem einfachen Trennvorgang auf Länge zu schneiden, wodurch sich die Vorsprünge von selbst ergeben. Durch die lochförmige Ausbildung der Ausnehmungen in den Seitenschenkeln der Träger ist es möglich, eine entsprechend angepasste Steckmutter zu verwenden, ohne dafür zusätzliche Durchbrüche ausbilden zu müssen. Dies bedeutet, dass ausser dem Trennen kein zusätzlicher Arbeitsgang zur Ausbildung der Trägerenden erforderlich ist. Der Träger kann im ungebogenen Zustand oder im gebogenen Zustand z. B. durch Sägen getrennt werden. In diesem Fall ist es möglich, das Stangenmaterial bereits im gebogenen Zustand anzuliefern.

Weiterbildungen der Erfindung sind in den Ansprüchen 2 bis 10 gekennzeichnet.

Durch die Weiterbildung nach Anspruch 2 ist es möglich, den ungebogenen Träger in einem abfallfreien Schervorgang etwa in der Mitte der Ausnehmungen zu trennen und dadurch die Vorsprünge zu erzeugen. Durch die Weiterbildung nach Anspruch 3 wird erreicht, dass die Führungsschienen mit einer einfachen geradlinigen Bewegung an den Trägern befestigt werden können. Die Rasthaken ragen in Richtung der Ausnehmungen und werden beim Einsetzen in diese seitlich ausgelenkt. In der Endstellung federn sie zurück und hintergreifen die Träger. Die Auslenkung der Rasthaken erfolgt senkrecht zur Erstreckungsrichtung der Führungsschienen. Da an einer Führungsschiene jeweils zwei Rasthaken gleichzeitig gegeneinander federn, heben sich die seitlichen Federkräfte auf. Dadurch wird ein Kippen oder Verdrehen der Führungsschiene bei der Montage vermieden. Durch die lochförmige Ausgestaltung der Ausnehmungen und durch das Anpassen der Rasthakenbreite an die entsprechende Abmessung der Ausnehmung ist es möglich, die Führungsschiene nicht nur in der Quer- sondern auch in der Längsrichtung am Träger zu fixieren.

Nach dem Stand der Technik muss die Führungsschiene beim Einsetzen und Entfernen so weit durchgebogen werden, dass ihre Anschlagfläche an der entsprechenden Gegenanschlagfläche des Trägers vorbeigleiten kann. Dieses Durchbiegen erfordert einige Geschicklichkeit, da bei zu starkem Durchbiegen Bruchgefahr besteht und da bei schwachem Durchbiegen das Ent- oder Verriegeln misslingen kann.

Die Weiterbildung nach Anspruch 5 ermöglicht es, die Verrastung in den Ausnehmungen durch einfaches Zusammendrücken der Führungsschiene im Bereich des Längsschlitzes zu lösen.

Durch die Weiterbildung der Erfindung nach Anspruch 6 ist es möglich, die gleiche Führungsschiene sowohl für die obere als auch die untere Führung einer Baugruppe zu verwenden. Durch die symmetrische Anordnung der Rasthaken kommt es zu keinem seitlichen Versatz der Führungsbahn.

Durch die Weiterbildung nach Anspruch 7 wird erreicht, dass die Stützbleche nun direkt an den Trägern befestigt werden können. Es entfallen das aufwendige Verschrauben und die Verbindungsstücke zum Befestigen an den Trägern. Das Stützblech liegt z. B. mit einer Seitenkante an dem Träger an. Die Fortsätze, die von dieser Seitenkante ausgehen, sind durch die zugehörige lochförmige Ausnehmung in einfacher Weise hindurchgesteckt und hintergreifen den Träger mit den seitlichen Nasen. Diese sind federnd an die hintergriffene Seitenwand des Durchbruches angedrückt und dadurch in ihrer Lage gegenüber dem Träger gesichert. Es ist aber auch möglich, an einem Fortsatz seitliche Nasen zu beiden Seiten des Durchbruches anzuordnen. Die in der gleichen Richtung weisenden Nasen umgreifen die Seitenwand des Durchbruches zu beiden Seiten. Die Höhe des Vorsprunges ist so bemessen, dass dieser zunächst tiefer als zur Fixierung erforderlich in den Durchbruch hineingesteckt werden kann. Beispielsweise sind alle Fortsätze auf der Oberseite des Stützbleches in dieser Weise ausgebildet. Dadurch ist es möglich, die oberen Fortsätze des anfangs schräg gestellten Stützbleches zunächst in die Durchbrüche der oberen Träger so tief einzustecken, dass sich die kürzeren unteren Fortsätze oberhalb der unteren Träger befinden. Diese werden dann in die entsprechenden unteren Durchbrüche hineingesteckt, bis die untere Kante des Stützbleches auf dem unteren Träger aufsitzt. Die längeren oberen Fortsätze ragen in dieser Lage noch immer durch die Durchbrüche der oberen Träger hindurch. Die Weite der Durchbrüche ist dabei grösser als die Höhe der seitlichen Nasen der Fortsätze plus der Dicke des Stützbleches. Ein besonderer Vorteil liegt darin, dass nun das Stützblech auch noch in den bereits fertig gestellten Baugruppenrahmen ohne besondere Mühe eingesetzt werden kann. Ebenso ist es möglich, bei einer Änderung das Stützblech an eine andere Stelle zu versetzen. Es ist möglich, die Federkraft zum seitlichen Andrücken der Fortsätze des Stützbleches mittels abgebogener Lappen des Stützbleches aufzubringen.

Durch die Weiterbildungen nach den Ansprüchen 8 und 9 ist es jedoch möglich, die Lagesicherung der Stützbleche getrennt von dem Einsetzen in den Baugruppenrahmen vorzunehmen. Dies erleichtert die Montage und vor allem auch die Demontage des Stützbleches. Die Andrückfedern können sukzessive eingesetzt oder entfernt werden. Sie können als einfache Drahtbügel ausgebildet sein, die zwischen der anderen Seitenwand des Durchbruches und dem Fortsatz des Stützbleches federnd eingeklemmt sind. Das Einstecken und Entfernen der Andrückfedern, ist ohne zusätzliche Hilfsmittel in einfacher Weise durchzuführen.

Im folgenden wird die Erfindung anhand eines in der Zeichnung dargestellten Ausführungsbeispieles näher erläutert. Es zeigen:

Fig. 1 in perspektivischer Ansicht einen Rahmen zur Aufnahme von einschiebbaren elektrischen Baugruppen unmittelbar vor dem Zusammenbau, wobei die Montagerichtung der einzelnen Teile durch strichpunktierte Linien angedeutet ist;

Fig. 2 eine Seitenansicht eines Trägers zur Befestigung von Führungsschienen für die Baugruppe mit einem Seitenblech des Magazins sowie einer Befestigungsschraube für die Träger und einer Steckmutter;

Fig. 3 die Teile nach Fig. 2 in einer Stirnansicht des Trägers;

Fig. 4 eine Seitenansicht auf einen Teil einer der Führungsschienen mit dem Träger;

Fig. 5 eine Draufsicht auf die Teile nach Fig. 4;

Fig. 6 einen vergrösserten Schnitt entlang der Linie VI–VI in Fig. 4;

Fig. 7 eine Seitenansicht eines Stützbleches, das an den Trägern befestigt ist;

Fig. 8 einen Schnitt entlang der Linie VIII–VIII in Fig. 1;

Fig. 9 einen Schnitt entlang der Linie IX–IX in Fig. 1.

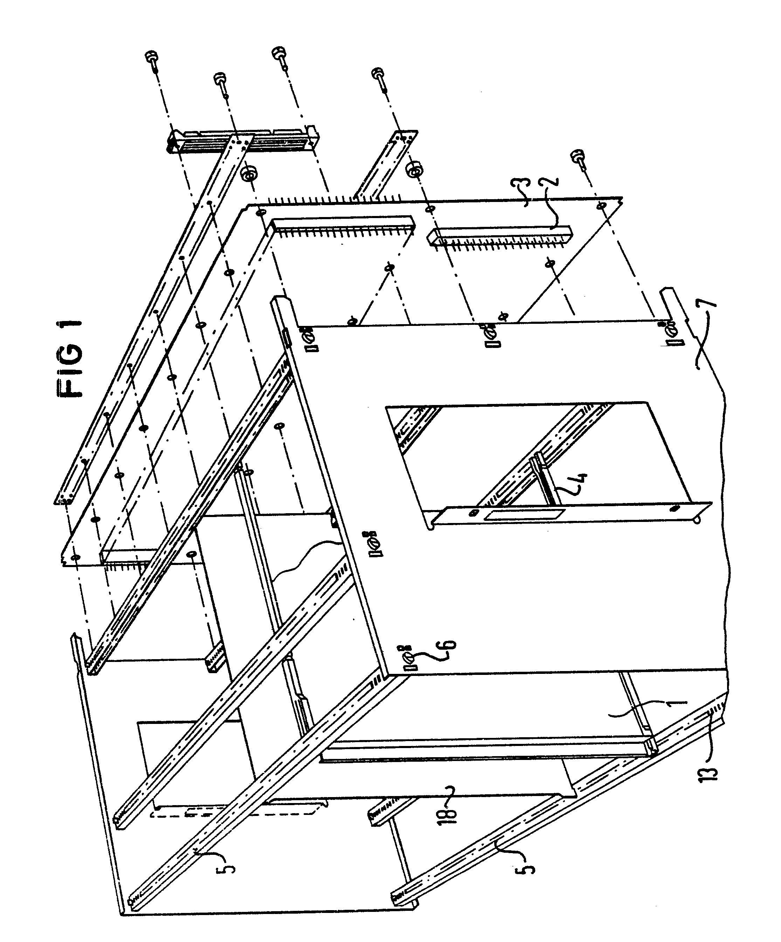

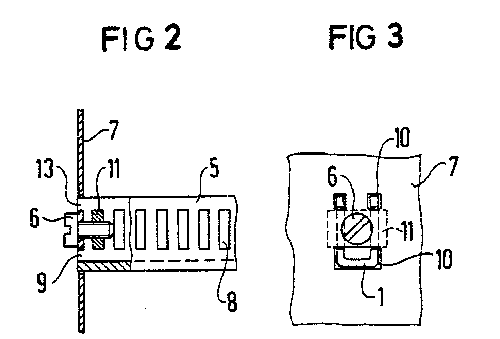

Nach Fig. 1 sind die einschiebbaren elektrischen Baugruppen 1 über Rückwandstecker 2 durch eine Rückwandverdrahtung verbindbar. Diese Rückwandverdrahtung weist eine gedruckte Schaltungsplatte 3 auf, die sich über die gesamte Magazinrückwand erstreckt. Die Baugruppen 1 sind in Führungsschienen 4 gehalten, die an sich senkrecht zu diesen erstreckenden, waagerechten stangenartigen Trägern 5 befestigt sind. Diese sind an ihren Stirnseiten mittels Befestigungsschrauben 6 an Seitenblechen 7 des Magazins befestigt. Nach den Fig. 2 und 3 ist der U-förmig gebogene Träger 5 durchgehend mit rasterartig verteilten Ausnehmungen 8 in Form von Rechtecklöchern versehen. Diese Ausnehmungen 8 sind paarweise fluchtend in den Seitenschenkeln des Trägers 5 angeordnet. Dieser ist an seinem Ende ungefähr in der Mitte eines der Ausnehmungspaare abgeschnitten. Entsprechend dem Restquerschnitt des Trägers 5 bilden sich somit an dieser Stelle Vorsprünge 9, 13 an den Stirnseiten des Trägers 5. Dieser ist an seinem Ende mit dem Seitenblech 7 fest verbunden. Die Vorsprünge 9 ragen in entsprechende Durchbrüche 10 des Seitenbleches 7 hinein. Eine flache Steckmutter 11 ist in das benachbarte Ausnehmungspaar eingesetzt. Die Befestigungsschraube 6 ist von der Aussenseite des Seitenbleches 7 her fest in die Steckmutter 11 eingeschraubt und zieht damit den Träger 5 gegen das Seitenblech 7. Damit ist sichergestellt, dass die Vorsprünge 9 nicht aus den Durchbrüchen 10 herausgezogen werden können.

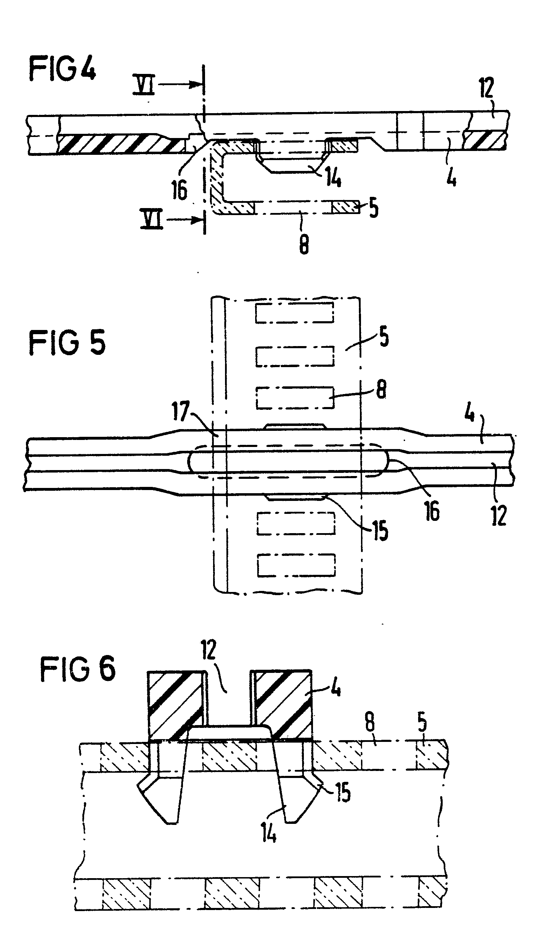

Nach den Fig. 4 bis 6 ist die Führungsschiene 4 mit einer Längsnut 12 versehen, in der die Leiterplattenkante der Baugruppe 1 (Fig. 1) geführt ist. Die Führungsschiene 4 ist an dem strichpunktiert angedeuteten Träger 5 des Baugruppenmagazins befestigt. Sie liegt auf einem der Seitenschenkel des Trägers 5 auf. Sie weist in diesem Bereich zwei Rasthaken 14 auf, die durch zwei benachbarte Ausnehmungen 8 des Trägers 5 hindurchragen und mit seitlichen Nasen 15 den betreffenden Seitenschenkel des Trägers 5 hintergreifen. Die Rasthaken 14 sind in bezug auf die Mittelachse der Längsnut 12 der Führungsschiene 4 symmetrisch angeordnet. Die seitlichen Nasen 15 sind auf den einander abgewandten Aussenseiten der Rasthaken 14 angeordnet. Die Führungsschiene 4 weist im Bereich der Rasthaken 14 einen mittigen Längsschlitz 16 auf, der zwischen den beiden Rasthaken 14 verläuft. Dadurch bilden sich an der Führungsschiene 4 zwei verhältnismässig schmale flexible Längsstege 17, die die Rasthaken 14 tragen. Beim Einsetzen in die Ausnehmungen 8 der Träger 5 werden die Rasthaken 14 seitlich ausgelenkt. Diese Auslenkung überträgt sich auf die Längsstege 17 derart, dass die Rasthaken 14 in sich starr und daher sehr kompakt ausgeführt werden können.

Die beiden benachbarten Rasthaken 14 sind federnd zwischen den einander abgewandten Aussenwänden der beiden benachbarten Ausnehmungen 8 verspannt. Die Länge der Rasthaken 14 in der Erstreckungsrichtung der Führungsschiene 4 entspricht die Länge der Ausnehmungen 8. Damit ist die Führungsschiene 4 in ihrer Länge gegenüber dem Träger 5 genau fixiert. Zum Lösen der Führungsschiene 4 müssen lediglich die Längsstege 17 zusammengedrückt werden. Dieser Vorgang erfolgt von der leicht zugänglichen Einschubseite aus und lässt sich entsprechend bequem bewerkstelligen. Noch einfacher lässt sich das Einsetzen mit einer einfachen Eindrückbewegung durchführen. Die Führungsschiene 4 kann aufgrund ihres symmetrischen Aufbaues sowohl für die obere als auch für die untere Führung der Baugruppe 1 verwendet werden. Da für die beiden Rasthaken 14 je eine Ausnehmung 8 vorgesehen ist, ergibt sich für die Ausnehmungen 8 entlang des Trägers 5 eine feinere Unterteilung, die eine grössere Variabilität bei der Bestückung des Baugruppenmagazins mit unterschiedlich breiten Baugruppen 1 ermöglicht.

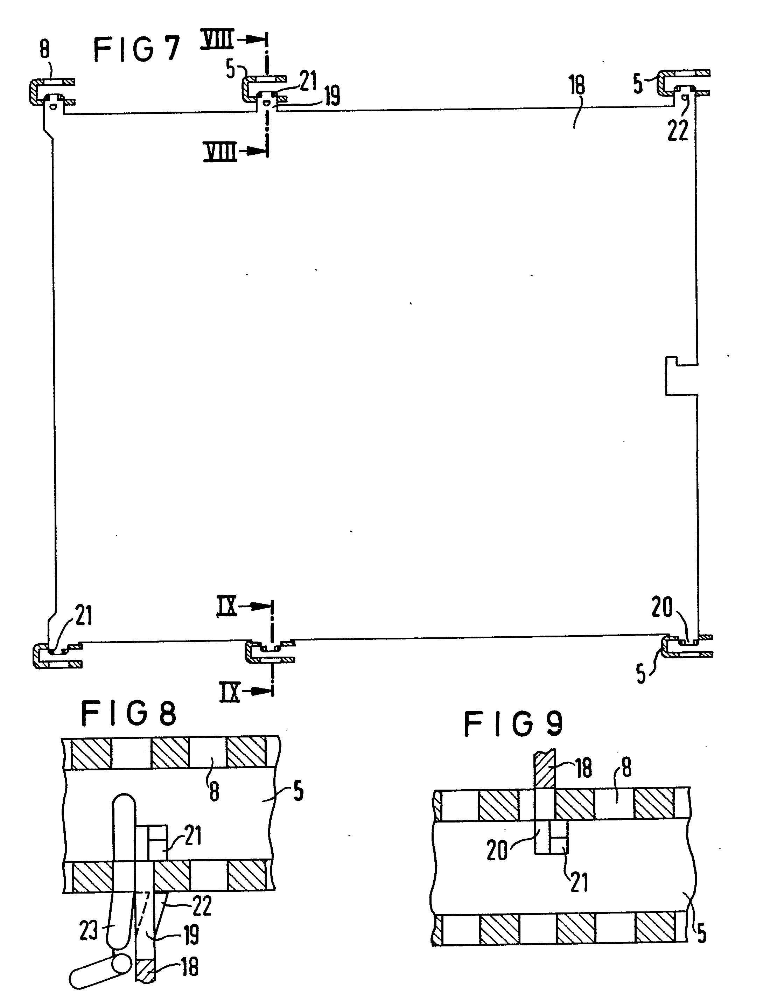

Die Fig. 7, 8 und 9 zeigen ein Stützblech 18 zur mechanischen Stabilisierung des Baugruppenmagazins. Das Stützblech 18 ist zwischen den Baugruppen 1 (Fig. 1) angeordnet und erstreckt sich parallel zu diesen. Es ist mit den Trägern 5 fest verbunden. Diese dienen sowohl der Befestigung der Führungsschienen 4 für die Baugruppe 1 als auch der Aufnmahme des Stützbleches 18. Dieses weist an seinen Seitenkanten Fortsätze 19, 20 auf, die in die Ausnehmungen 8 der Träger 5 hineinragen. Die Fortsätze 19, 20 sind mit seitlich ausgeprägten Haltenasen 21, 22 versehen. Sie liegen auf der Seite der seitlichen Haltenasen 21 und 22 an der entsprechenden Innenwand der jeweiligen Ausnehmung 8 an. Sie werden in dieser Lage durch Andrückfedern 23 gehalten, die in die Ausnehmungen 8 eingesprengt sind. Die Haltenasen 21 hintergreifen dadurch zuverlässig den dem Stützblech 18 zugewandten Seitenschenkel des U-förmig gebogenen Trägers 5.

Die Fortsätze 19 und 20 weisen eine unterschiedliche Höhe auf. Das Stützblech 18 liegt mit seiner Unterkante auf den unteren Trägern 5 auf. Die oberen Fortsätze 19 sind so lang, dass zwischen der Oberkante des Stützbleches 18 und den oberen Trägern 5 ein Abstand besteht, der grösser ist als die Höhe der unteren Fortsätze 20. Dadurch ist es möglich, ein Stützblech 18 auch nach der Fertigstellung des Baugruppenmagazins einzubauen. Die zusätzlichen seitlichen Haltenasen 22 der oberen Fortsätze 19 weisen annähernd die gleiche Höhe auf wie die Haltenasen 21. Der dem Stützblech 18 zugewandte Seitenschenkel der oberen Träger 5 ist von den beiden Haltenasen 21 und 22 umgriffen. Dadurch ist das Stützblech 18 auch gegenüber den oberen Trägern 5 in seiner Lage fixiert. Die Länge der Fortsätze 19 und 20 ist der Länge der Ausnehmungen 8 in den Trägern 5 angepasst, so dass die gegenseitige Lage auch in dieser Richtung festgelegt ist.

**Patentansprüche**

1. Magazin zur Aufnahme von einschiebbaren elektrischen Baugruppen (1), die in Führungsschienen (4) gehalten sind, welche an sich quer zu diesen erstreckenden U-förmigen, stangenartigen Trägern (5) anliegen und mit nasenartigen Erhebungen in entsprechende gleichmässig und über die gesamte Länge der Träger (5) durchgehend aneinandergereihte Ausnehmungen (8) der Träger (5) eingreifen, die an ihren Enden fest mit Seitenblechen (7) des Magazins verbunden sind, wobei stirnseitige Vorsprünge (9) des Trägers (5) in entsprechende Durchbrüche (10) des Seitenbleches (7) eingreifen, wobei eine Steckmutter (11) in der Nähe des Seitenbleches (7) in Durchbrüche des Trägers eingesetzt und mittels einer Befestigungsschraube (6) mit dem Seitenblech (7) verspannt ist und wobei zwischen den Baugruppen (1) zumindest ein Stützblech (18) angeordnet und an den Trägern (5) befestigt ist, dadurch gekennzeichnet, dass die Ausnehmungen (8) als lochförmige, rechteckige Durchbrüche ausgebildet sind, die paarweise fluchtend in den Seitenschenkeln des Trägers (5) angeordnet sind, dass die Stirnflächenebene des Trägers (5) in den Bereich eines der Ausnehmungspaare (8) gelegt ist, dass der Querschnitt der Vorsprünge (9) gleich dem Querschnitt des Trägers (5) im Bereich der Ausnehmungspaare (8) ist und dass die Steckmutter (11) in eines der Ausnehmungspaare (8) eingesetzt ist.

2. Magazin nach Anspruch 1, dadurch gekennzeichnet, dass die Höhe der Vorsprünge (13) annähernd gleich der halben Breite der Ausnehmungen (8) ist.

3. Magazin nach Anspruch 1 oder 2, dadurch gekennzeichnet, dass die Erhebungen an den Führungsschienen (4) als federnde Rasthaken (14) ausgebildet sind, die durch die lochförmigen Ausnehmungen (8) hindurchragen und die Träger (5) hintergreifen, dass die Rasthaken (14) senkrecht zur Erstreckungsrichtung der Führungsschienen (4) federnd ausgebildet sind, dass in zwei benachbarte Ausnehmungen (8) zwei gegeneinander federnde Rasthaken (14) jeweils einer der Führungsschienen (4) eingreifen und dass die lichte Weite der Ausnehmungen (8) in Längsrichtung der Führungsschienen (4) der entsprechenden Breite der Rasthaken (14) angepasst ist.

4. Magazin nach Anspruch 3, dadurch gekennzeichnet, dass die Führungsschienen (4) zwischen den Rasthaken (14) mittig längs geschlitzt sind.

5. Magazin nach Anspruch 3 oder 4, dadurch gekennzeichnet, dass die seitlich vorspringenden Nasen (15) der Rasthaken (14) einander abgewandt sind.

6. Magazin nach Anspruch 3, 4 oder 5, dadurch gekennzeichnet, dass die Rasthaken (14) der Führungsschiene (4) symmetrisch zu einer Längsnut (12) zur Führung der Baugruppen angeordnet bzw. ausgebildet sind und dass die Mitte der Längsnut (12) in der Mitte zwischen zwei direkt benachbarten Ausnehmungen (8) des Trägers (5) liegt.

7. Magazin nach einem der Ansprüche 1 bis 6, dadurch gekennzeichnet, dass das Stützblech (18) mit Fortsätzen (19, 20), in die die lochförmigen Ausnehmungen (8) hineinragen, dass die Fortsätze (19, 20) seitlich ausgeformte Haltenasen (21) aufweisen, die die Träger (5) hintergreifen und die Fortsätze (19, 20) an der von den Haltenasen (6) hintergriffenen Seitenwand der Ausnehmungen (8) anliegen und in dieser Lage durch Verriegelungselemente (z. B. 23) gehalten sind.

8. Magazin nach Anspruch 7, dadurch gekennzeichnet, dass in die jeweiligen Ausnehmungen (8) separate Andrückfedern (23) als Verriegelungselemente eingesprengt sind.

9. Magazin nach Anspruch 8, dadurch gekennzeichnet, dass die Andrückfedern (23) aus Federdraht gebogen sind.

**Claims**

1. A rack for accommodating slidable electrical elements (1), which are secured in guide rails (4) which rest on U-section, bar-shaped carriers (5) which extend transversely to the latter, and which engage by means of nose-like projections into corresponding recesses (8) in the carriers (5) which are continuously spaced along the entire length of the carriers (5), and which carriers at their ends are fixedly connected to side plates (7) of the rack, wherein end face projections (9) of the carrier (5) engage into corresponding openings (10) in the side plate (7), wherein in the vicinity of the side plate (7), a plug-in nut (11) is inserted into the opening of the carrier and attached to the side plate (7) by means of a fastening screw (6), and wherein at least one supporting plate (18) is arranged between the elements (1) and secured to the carriers (5), characterised in that the recesses (8) are formed as rectangular holes which are aligned in pairs in the side arms of the carriers (5); that the plane of the end face of the carrier (5) is introduced into the region of one of the pairs of recesses (8); that the cross-section of the projections (9) equals the cross-section of the carrier (5) in the region of the pair of recesses (8); and that the plug-in nut (11) is inserted into one of the pairs of recesses (8).

2. A rack as claimed in claim 1, characterised in that the height of the projections (13) is approximately equal to half the width of the recesses (8).

3. A rack as claimed in claim 1 or claim 2, characterised in that the projections on the guide rails (4) are designed as resilient catch hooks (14) which protrude through the hole-shaped recesses (8) and engage behind the carriers (5); that the catch hooks (14) are so designed as to be sprung at right angles to the direction of the guide rails (4); that two catch hooks (14) of one of the guide rails (4) which are sprung against one another, engage into two adjacent recesses (8); and that the inside width of the recesses (8) is matched to the corresponding width of the catch hooks (14) in the longitudinal direction of the guide rails (4).

4. A rack as claimed in claim 3, characterised in that between the catch hooks (14), the guide rails (4) are centrally slotted lengthwise.

5. A rack as claimed in claim 3 or claim 4, characterised in that the laterally projecting noses (15) of the catch hooks (14) face away from one another.

6. A rack as claimed in claim 3, 4 or 5, characterised in that the catch hooks (14) of the guide rail (4) are arranged or designed, as the case may be, symmetrically with respect to a longitudinal groove (12) for guiding the elements; and that the centre of the longitudinal groove (12) lies centrally between two immediately adjacent recesses (8) of the carrier (5).

7. A rack as claimed in one of claims 1 to 6, characterised in that the supporting plate (18) protrudes in to the hole-shaped recesses (8) with shoulders (19, 20); that the shoulders (19, 20) have laterally formed holding noses (21) which engage behind the carriers (5), and the shoulders (19, 20) rest against the side wall of the recesses (8) into which the holding noses (6) engage from behind, and are held in this position by locking elements (e. g. 23).

8. A rack as claimed in claim 7, characterised in that separate compression springs (23) are snap-fitted into the respective recesses (8) as locking elements.

9. A rack as claimed in claim 8, characterised in that the compression springs (23) are bent from resilient wire.

**Revendications**

1. Baie destinée à recevoir des modules électriques enfichables (1), qui sont maintenus dans des glissières (4), qui sont appliquées contre des supports (5) du type à barre en forme de U, s'étendant transversalement par rapport aux glissières et qui s'engagent par des protubérences en forme de becs dans des ouvertures correspondantes (8) des supports (5), qui se succèdent suivant une rangée d'une manière uniforme et continue sur toute la longueur des supports (5), qui sont reliés rigidement, à leurs extrémités, à des tôles latérales (7) de la baie, des parties saillantes frontales (9) du support (5) s'engageant dans des perçages correspondants (10) de la tôle latérale (7), alors qu'un écrou enfichable (11) est inséré à proximité de la tôle latérale (7) dans des perçages du support et est bloqué par serrage sur la tôle latérale (7) à l'aide d'une vis de fixation (6), et qu'au moins une tôle de soutien (18) est disposée entre les modules (1) et est fixée aux supports (5), caractérisé par le fait que les ouvertures (8) sont réalisées sous la forme de perçages en forme de trous rectangulaires, qui sont disposés en étant alignés, par couples, dans les branches latérales du support (5), que le plan de la face frontale du support (5) est situé au voisinage de l'un des couples d'ouver-

5

tures (8), que la section transversale des parties saillantes (9), est égale à la section transversale du support (5), au voisinage des couples d'ouvertures (8), et que les écrous enfichables (11) sont insérés dans l'un des couples d'ouvertures (8).

2. Baie suivant la revendication 1, caractérisée par le fait que la hauteur des parties saillantes (13) est égale approximativement à la moitié de la largeur des ouvertures (8).

3. Baie suivant la revendication 1 ou 2, caractérisée par le fait que les protubérances situées sur les glissières (4) sont réalisées sous la forme de crochets élastiques d'encliquetage (14) qui pénètrent dans les ouvertures en forme de trous (8) et s'engagent derrière les supports (5), que les crochets d'encliquetage (14) sont réalisés de manière à être élastiques, perpendiculairement à la direction d'extension des glissières de guidage (4), que deux crochets d'encliquetage (14), présentant des actions élastiques antagonistes, de l'une des glissières (4) s'engagent dans deux ouvertures voisines (8) et que l'étendue des ouvertures (8) suivant la direction longitudinale des glissières (4) est adaptée à la largeur correspondante des crochets d'encliquetage (14).

4. Baie suivant la revendication 3, caractérisée par le fait que les glissières (4) sont fendues longitudinalement dans leur partie médiane entre les crochets d'encliquetage (14).  ·

5. Baie suivant la revendication 3 ou 4, caractérisée par le fait que les becs (15), qui font saillie latéralement, des crochets d'encliquetage (14) sont tournés à l'opposé les uns des autres.

6. Baie suivant la revendication 3, 4 ou 5, caractérisée par le fait que les crochets d'encliquetage (14) de la glissière (4) sont disposés ou réalisés symétriquement par rapport à une rainure longitudinale (12) servant au guidage des modules, et que la partie médiane de la rainure (12) est disposée dans la partie médiane située entre deux ouvertures (8), directement voisines, du support (5).

7. Baie suivant l'une des revendications 1, 5 à 6, caractérisée par le fait que la tôle de soutien (18) pénètre par des appendices saillants (19, 20) dans les ouvertures en forme de trous (8), que les appendices saillants (19, 20) comportent des becs de maintien (21) ressortis latéralement par façonnage et qui s'engagent derrière les supports (5) et appliquent les appendices saillants (19, 20) contre la paroi latérale des ouvertures (8), derrière laquelle s'accrochent les becs de maintien (6), et sont maintenus dans cette position par des organes de verrouillage (par exemple 23).

8. Baie suivant la revendication 7, caractérisée par le fait que des ressorts de pression (23) séparés sont insérés en tant qu'organes de verrouillage dans les évidements respectifs (8).

9. Baie suivant la revendication 8, caractérisée par le fait que les ressorts de pression (23) sont constitués par un fil pour ressort replié.

FIG 1

0 062 108

# FIG 2

# FIG 3

**FIG 4**

**FIG 5**

**FIG 6**

FIG 7

FIG 8

FIG 9